# EUROPEAN PATENT SPECIFICATION

(11) **EP 1 915 769 B1**
(45) Date of publication and mention of the grant of the patent: **11.05.2011**
(21) Application number: 06765117.4
(22) Date of filing: 27.07.2006
(51) Int. Cl.: H01J 37/32

(54) **Method of treating a gas stream**
Verfahren zum Behandeln eines Gasstroms
Procédé de traitment d'un flux gazeux

(30) Priority: 15.08.2005 GB 0516695; 27.10.2005 GB 0521961
(43) Date of publication of application: 30.04.2008
(73) Proprietor: Edwards Limited, Crawley, West Sussex RH10 9LW (GB)
(72) Inventor: SMITH, James, Robert, c/o Edwards Limited, North Somerset BS21 6TH (GB); SEELEY, Andrew, James, c/o Edwards Limited, North Somerset BS21 6TH (GB); BAKER, Derek, Martin, c/o Edwards Limited, North Somerset BS21 6TH (GB); RADIOU, Marilena, c/o Edwards Limited, Clevedon, North Somerset BS21 6TH (GB)
(74) Representative: Clark, Charles Robert
(86) International application number: PCT/GB2006/002795
(87) International publication number: WO 2007/020374

(56) References cited:
- EP-A1- 1 093 849
- EP-A1- 1 297 891

## Description

The present invention relates to a method of treating a gas stream using a plasma abatement device. The invention is particularly suitable to the treatment of a gas stream exhaust from a polysilicon etch process.

During the formation of a semiconductor or flat panel display device, various different process gases are supplied to various process chambers. Chemical vapour deposition (CVD) is used to deposit thin films or layers on the surface of a substrate or wafer located in a deposition chamber. This process operates by supplying one or more reactive gases to the chamber, often using a carrier gas, to the substrate's surface under conditions that encourage chemical reactions to take place at the surface. For example, TEOS and one of oxygen and ozone may be supplied to the deposition chamber for the formation of a silicon oxide layer on the substrate, and silane and ammonia may be supplied for the formation of a silicon nitride layer. Polycrystalline silicon, or polysilicon, is deposited on the substrate by the decomposition of silane or a chlorosilane by heat.

Gases are also supplied to an etch chamber to perform selective etching of areas of the deposited layers, for example during the formation of electrodes and the source and drain regions of a semiconductor device. Etching gases can include the perfluorocompounds such as CF₄, CHF₃ and NF₃, other halocompounds such as HCl, HBr, BCl₃, Cl₂ and Br₂, and combinations thereof. For example, CF₄ is commonly used to initially form an opening in a region of a nitride or oxide layer formed over a polysilicon layer and which is exposed by a photoresist layer, and a mixture of HBr and Cl₂ is commonly used to subsequently etch the exposed polysilicon.

The etching gases can react with a photoresist to form deposits and tars that need to be periodically removed from the etch chamber, and so a cleaning gas, typically comprising SF₆ and oxygen, is periodically supplied to the etch chamber to remove the unwanted material from the chamber.

During these etch and cleaning processes performed within the etch chamber, there is typically a residual amount of the gas supplied to the etch chamber contained in the gas exhaust from the etch chamber. Perfluorocompounds such as CF₄ and SF₆ are highly dangerous if exhausted to the atmosphere, and so in view of this, before the exhaust gas is vented to the atmosphere, an abatement device is often provided to treat the exhaust gas. The abatement device converts the more hazardous components of the exhaust gas into species that can be readily removed from the exhaust gas, for example by conventional scrubbing, and/or can be safely exhausted to the atmosphere.

Perfluorocompounds (PFCs) such as CF₄, SF₆, NF₃ and C₂F₆ can be removed from the gas stream with high efficiency using a microwave plasma abatement device. An example of a microwave plasma reactor is described in UK Patent no. GB 2,273,027. In that device, a waveguide conveys microwave radiation from a microwave generator into a gas chamber housing two electrodes in a closely opposed relationship. A gas to be treated flows into the gas chamber through a gas inlet, and passes between the electrodes, so that a microwave plasma is initiated and sustained between the two electrodes from the gas flowing between the electrodes. One of the electrodes has an axial hole to provide a gas outlet from the gas chamber. Under the intensive conditions within the plasma, species within the gas stream are subjected to impact with energetic electrons causing dissociation into reactive species that can combine with oxygen or hydrogen to produce relatively stable by-products.

EP 1093849 A1 discloses a method and a device for decomposing organohalogen compounds with microwaver by generating a thermal plasma and reacting φ the organohalogen compounds with steam in the thermal-plasma.

A convenient source of oxygen and hydrogen for reacting with the various species contained in the gas stream is water vapour, which may be readily added to the gas stream upstream from the abatement device. For example, reaction of CF₄ with water vapour will form CO₂ and HF, and Cl₂ can form HCl within the chamber. HF, HCl and HBr can be subsequently removed from the gas stream by a wet scrubber located downstream from the abatement device.

Various parts of a plasma abatement device, such as one or more of the electrodes, electrode holders and the inner surface of the chamber, are typically formed from stainless steel. In addition to iron, carbon, and chromium, stainless steel may also contain other elements, such as nickel, molybdenum, niobium and titanium. In the presence of air, a passive surface oxide layer is formed, which protects the underlying stainless steel from corrosion. However, in the presence of acidic gases such as HF, HCl, and HBr, the passive layer can be stripped, exposing the underlying stainless steel. For example, HF may be present in the gas chamber as a by-product of the treatment of a perfluorocompound within the gas chamber, and HCl or HBr may be contained in the gas exhaust from the process chamber during an etching process.

Once the nickel oxide layer has been removed, HBr, and HCl can react with the metals contained in the stainless steel when moisture levels are in excess of a few parts per million (ppm). Due to the water adsorbed on the stainless steel surface, the by-products of these reactions can degrade the gas chamber and the electrodes, which can reduce the efficiency of the abatement device.

It is an aim of at least the preferred embodiment of the present invention to provide an improved method of treating a gas stream containing varying amounts of a halocompound, such as HBr, HCl, Br₂ and Cl₂, and water vapour using a plasma abatement device.

In a first aspect, the present invention provides a method of treating a gas containing varying amounts of a halocompound and water vapour, the method comprising the steps of providing a plasma abatement device comprising a gas chamber having a gas inlet for receiving the gas and a gas outlet, heating the chamber to a temperature that inhibits adsorption of water on a stainless steel surface within the chamber, conveying the gas to the gas chamber for treatment thereof within the chamber, characterised in that the chamber is maintained within the range from 120°C to 180°C during treatment of the gas.

By heating the gas chamber in this manner to prevent the adsorption of water on any stainless steel surface within the chamber, the reaction of corrosive hydrogen halides, such as HBr and HCl, Br₂ or Cl₂ with the metals contained in the stainless steel can be inhibited, as there is insufficient moisture present for the reaction to take place. We have found that maintaining the chamber at a temperature in excess of 124°C can significantly increase the lifetime of any stainless steel components that are exposed to the gas passing through the gas chamber. This is different to simply heating the chamber above the dew point, as water adsorption at a stainless steel surface may still take place if the temperature of the chamber is not heated sufficiently above the dew point to inhibit water adsorption on the stainless steel surface.

In order to prevent overheating of the chamber, the chamber is preferably maintained at a temperature range between 120 and 180°C. The chamber may be conveniently maintained in this temperature range by flowing a heat transfer fluid through a chamber temperature control circuit for controlling the temperature of the chamber, and controlling the temperature of the fluid. The chamber temperature control circuit may be located in part within a wall of the chamber, for example either above, below or surrounding the gas chamber. In the preferred embodiment, the chamber temperature control circuit extends about the gas outlet.

The temperature of the fluid may be controlled by flowing the fluid through heat exchange means, and controlling the heat exchange means to control the temperature of the fluid. The heat transfer fluid may be selectively cooled to a first fluid temperature, preferably less than 120°C, by a first heat exchanger, and selectively heated to a second fluid temperature greater than the first fluid temperature, preferably at least 120°C, by a second heat exchanger. The first heat exchanger may be a passive device, such as a non-insulated pipe of the temperature control circuit, for dissipating heat from the thermal fluid, or it may be an active device controlled by a controller. The second heat exchanger is preferably an active device controlled by the controller. The circuit may be configured such that the heat transfer fluid flows through both heat exchangers, or through only a selected one of the heat exchangers, depending on the temperature of the gas chamber. This temperature may be monitored using a temperature sensor located on the wall of the gas chamber. The heat transfer fluid may be provided by hot oil, diathermic fluid or other thermal fluid.

The chamber may be initially heated to said temperature by the heat transfer fluid prior to supply of the gas to the chamber. Alternatively, the chamber may be heated by operating the abatement device, which generates a plasma to treat the gas stream and which will transfer heat to the gas chamber, using an external heating device, or in any other convenient manner.

In the preferred embodiment, the plasma abatement device comprises a microwave plasma abatement device, but the invention may also be applicable to other types of plasma abatement device, for example a plasma torch abatement device, which may have stainless steel electrodes and/or a stainless steel gas chamber. The gas is preferably treated at or around atmospheric pressure by the abatement device.

In a second aspect, the present invention provides a plasma abatement device comprising a gas chamber having a gas inlet for receiving a gas to be treated by the device and a gas outlet, and thermal control means for maintaining the chamber at a temperature that inhibits adsorption of water on a stainless steel surface within the chamber during treatment of a gas containing a halocompound and water vapour, characterised the thermal control means is configured to maintain the chamber within a temperature range from 120°C to 180°C during treatment of the gas.

Features described above in relation to the first aspect of the invention are equally applicable to the second aspect, and vice versa.

Preferred features of the present invention will now be described, by way of example only, with reference to the accompanying drawings, in which:
Figure 1 is an external perspective view of a microwave plasma abatement device;
Figure 2 is a side view of the device of Figure 1;
Figure 3 is a cross-sectional view through the device along line A-A of Figure 2;
Figure 4 is a cross-sectional view through the device along line B-B of Figure 2;
Figure 5 is an enlarged view of region C identified in Figure 3; and
Figure 6 illustrates a chamber temperature control circuit for controlling the temperature of the gas chamber of the device.

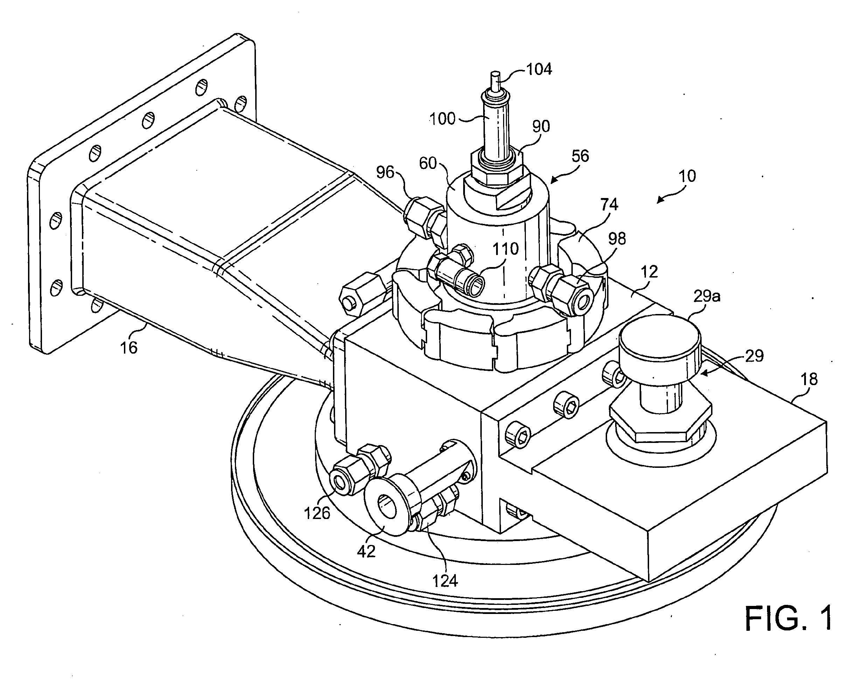

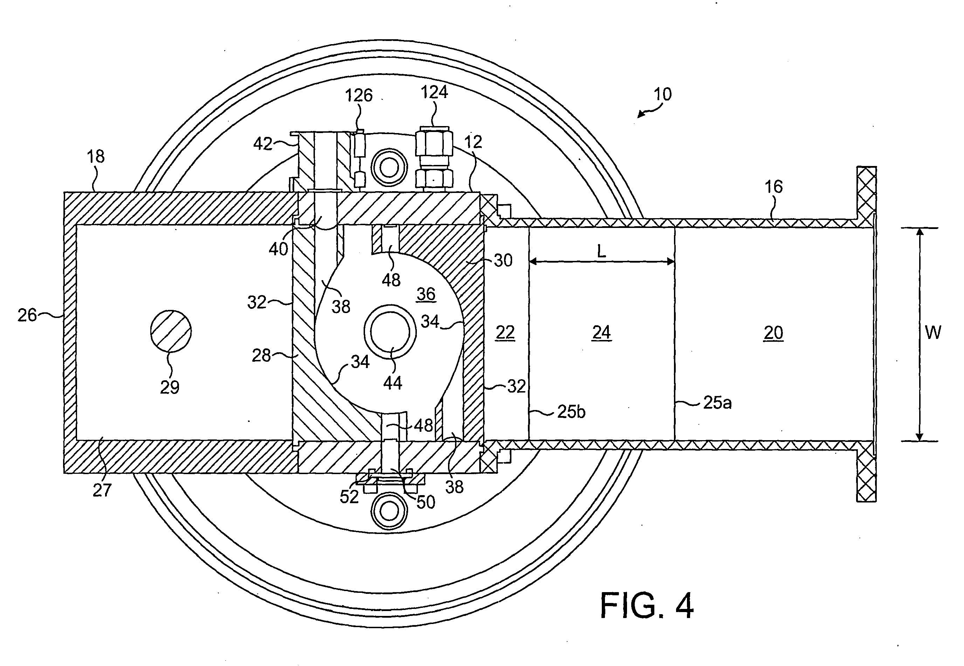

With reference to Figures 1 to 4, a microwave plasma abatement device 10 comprises an electrically conductive housing 12. The housing 12 is preferably formed from stainless steel. This may be an austenitic stainless steel, such as 304, 304L, 316, 316L, or other non-magnetic grade. As illustrated, the housing 12 may have a rectangular cross-section. A slot 14 is formed in the housing 12, for example by machining, and extends across the width of the housing 12 to provide a resonant cavity of the abatement device 10. One end of the resonant cavity 14 is connected to a waveguide 16 for conveying microwave radiation from a microwave generator (not shown) into the resonant cavity 14. The other end of the resonant cavity 14 is connected to a short circuit 18.

The waveguide 16 comprises a first, substantially rectangular body portion 20 having a height *h₁* substantially parallel to the TE₀₁ electric field of the microwave radiation conveyed through the waveguide 16 to the resonant cavity 14, and a width w orthogonal to the electric field of the microwave radiation. The waveguide 16 also comprises a second, substantially rectangular body portion 22 facing the resonant cavity 14, the second body portion 22 having a height *h₂* and a width *w*, where *h₂< h₁.* In the illustrated example, the second body portion 22 has a height of approximately one third of the height of the first body portion 20.

The waveguide 16 further comprises a tapered, convergent portion 24 of width w located between the first and second body portions 20, 22. The tapered portion 24 comprises a first end surface 25a adjacent the first body portion 20 of height *h₁* and width *w,* and a second end surface 25b adjacent the second body portion 22 of height h₂ and width *w.* The tapered portion 24 further comprises first and second side surfaces 25c, 25d extending between the end surfaces 25a, 25b and inclined at an acute angle to the second side surface 25b such that the first and second body portions 20, 22 are co-axial. The tapered portion 24 has a length / in the direction of propagation of the microwave radiation through the waveguide 16, where / is equal to approximately one half of the wavelength of the microwave radiation.

The short circuit 18 provides an extension of the waveguide 16 on the opposite side of the resonant cavity 14. The short circuit 18 comprises a chamber 27 defined in part by an end plate 26 that is distanced from the end of the second portion 22 of the waveguide 16 such that the incident microwave radiation is reflected by the end plate 26 to form an electromagnetic standing wave within the resonant cavity 14. The position of the end plate 26 relative to the end of the second portion 22 of the waveguide 16 may be adjustable.

The short circuit 18 comprises a tuner 29 spaced from the end plate 26 for tuning the short circuit 18. In the illustrated example, the tuner comprises a screw 29 threaded into the top surface of the short circuit 18 such that the body of the screw extends into the chamber 27 substantially perpendicular to the direction of propagation of the microwave radiation through the chamber 27. By turning the head 29a of the screw 29, the end of the screw 29 can be raised or lowered within the chamber 27 to tune the short circuit 18.

The resonant cavity 14 houses two dielectric plate members 28, 30, preferably formed from PTFE or other suitable material for retaining adequate corrosion resistance whilst being substantially transparent to the microwave radiation conveyed through the resonant cavity 14. Each plate member 28, 30 has a flat sidewall portion 32 extending orthogonally to the direction of propagation of the microwave radiation through the resonant cavity 14, and a curved sidewall portion 34 which define in part a substantially cylindrical gas chamber 36 within the resonant cavity 14. The gas chamber 36 may have a circular or elliptical cross-section.

Each plate member 30, 32 has a first bore 38 formed therein providing a gas inlet into the gas chamber 36 of the resonant cavity 14. In the illustrated abatement device 10, one of the bores 38 is aligned with a gas inlet port 40 formed in a sidewall of the housing 12 for receiving gas from a first gas conduit 42 mounted on the housing 12. A second gas port may optionally be formed in the opposite sidewall of the housing 12 for receiving gas from a second gas conduit, which gas may be the same as, or dissimilar to, the gas entering the gas chamber 36 from the first gas conduit 42. Each gas inlet is preferably configured so that gas enters the gas chamber 36 from the first gas conduit 40 substantially tangentially, so that the gas swirls inwardly within the gas chamber 36 towards the centre of the gas chamber 36. A gas outlet port 44 is formed in the base of the housing 12 for conveying gas from the gas chamber 36 to a second gas conduit 46. The gas outlet port 44 extends transversely of, and is preferably co-axial with, the gas chamber 36.

Each plate member 30, 32 also has a smaller second bore 48 formed therein. One of the bores 48 is aligned with an aperture 50 formed in a sidewall of the housing and closed by a transparent cover plate 52 to provide an inspection window for enabling a user to observe a plasma generated within the gas chamber 36 of the resonant cavity 14 during use of the abatement device 10.

A cylindrical bore 54 is also formed in the housing 12, the bore 54 extending transversely of the resonant cavity 14 and defining with the resonant cavity a gas chamber of the abatement device 10. The bore 54 is preferably substantially co-axial with the gas chamber 36 and gas outlet port 44. The bore 54, receives an electrically conducting assembly 56. The assembly 56 comprises an electrically conducting member 58 and a holder 60 for holding the electrically conducting member 58.

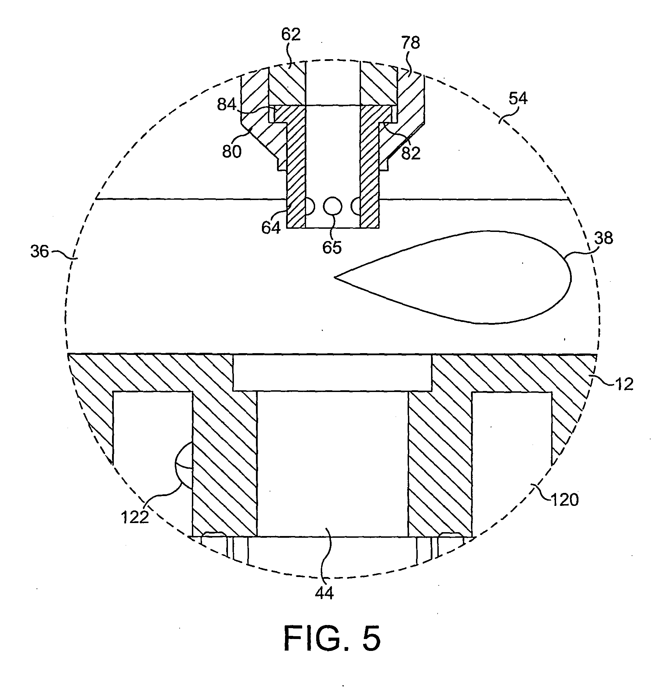

The electrically conducting member 58 comprises an elongate tube 62, which may be formed from copper or other electrically conducting material, and which engages a tubular tip 64, as illustrated in more detail in Figure 5. The tip 64 is preferably formed from corrosion and heat resistant material, such as tungsten or a tungsten alloy, for example an alloy of tungsten and lanthanum. The tip 64 may be provided with a plurality of apertures 65 extending thereabout to enable a gas flowing between the gas inlet 38 and the gas outlet 44 to pass radially through the tip 64 and thereby enhance the cooling of the tip 64. The apertures 65 are preferably dimensioned so that microwave radiation passes through the apertures 65.

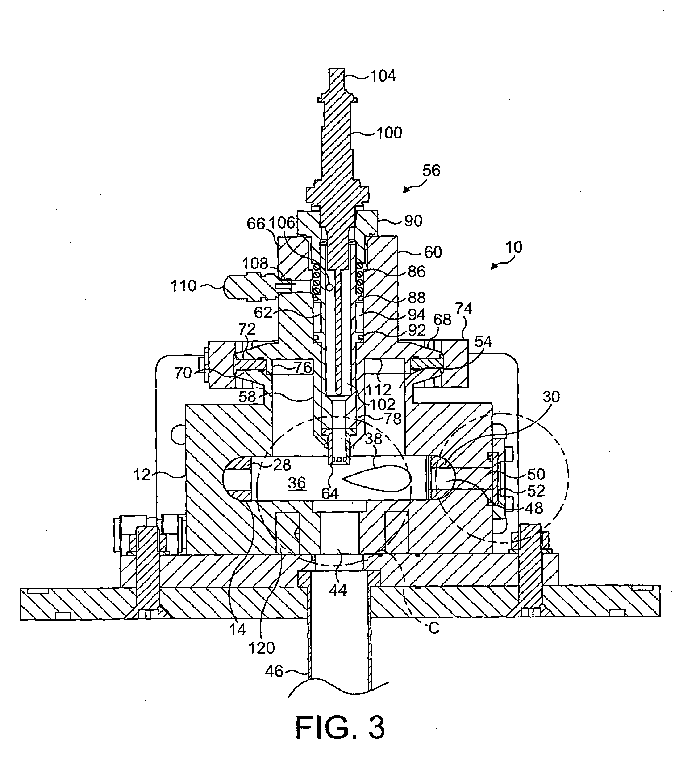

The holder 60 is preferably formed from electrically conducting material, such as stainless steel. This may be of similar grade to the housing 12, or a different grade. The electrically conducting member 58 and holder 60 are preferably at electrical ground during use of the abatement device 10. The holder 60 has a hollow interior within which the tube 62 and tip 64 of the electrically conducting member 58 are preferably a sliding fit. The holder 60 comprises a first body portion 66 having an outwardly extending skirt 68, which is located on a flanged opening 70 of the bore 54 of the housing 12. An O-ring 72 is provided between the skirt 68 and the flanged opening 70 to form an air-tight seal, the skirt 68 being clamped to the flanged opening 70 by a clamp chain 74 extending thereabout. As illustrated in Figure 3, the O-ring 72 is preferably located outside of the gas chamber and therefore outside of the electromagnetic field generated therein, and may extend about an annular ring 76 depending downwardly from the skirt 68, the annular ring having an inner diameter that is substantially equal to the diameter of the bore 54, and which makes electrical contact with the housing 12. Alternatively, the base of the skirt 68 may make electrical contact with the housing 12.

The holder 60 further comprises a second, elongate body portion 78 that extends into the bore 54. The second body portion 78 of the holder 60 terminates with a conical projection 80, which preferably does not protrude into the gas chamber 36. The internal diameter of the second body portion 78 decreases at the conical projection 80 to provide a shoulder 82 that engages a rim 84 of the tip 64 to retain the tip 64 within the holder 60. The second body portion 78 of the holder 60 is preferably integral with both the first body portion 66 and the skirt 68.

As illustrated in Figure 5, the tip 64 preferably protrudes into the gas chamber 36. The length of the tip 64, and/or the length of the second body portion 78 of the holder 60, is preferably chosen so that the tip 64 extends a predetermined distance into the standing wave generated within the resonant cavity 14 depending on the frequency of the microwave radiation supplied to the resonant cavity 14..

The tube 62 is preferably held in electrical contact with the holder 60. As illustrated, a metal spring 86 or other electrically conducting item, may be located within the holder 60 such that one end of the spring 86 engages a first annular projection 88 formed on the tube 62 and the other end of the spring 86 engages a metallic lock nut 90 threaded into the holder 60.

The tube 62 has a second annular projection 92 spaced from the first annular projection 88 to define an annular channel 94 between the holder 60 and the tube 62. A flow of cooling water is supplied to the annular channel 94, the water being supplied to the annular channel 94 through a coolant inlet port 96 passing through the holder 60, and being exhausted from the annular channel 94 through a coolant outlet port 98 passing through the holder 60 and located substantially opposite the coolant inlet port 96.

Depending on the power of the electromagnetic radiation conveyed to the resonant cavity, the intensity of electric field created within the resonant cavity 14 may be insufficient to ignite a plasma within the gas chamber 36. Therefore, a glow-discharge electrode assembly 100 may be housed within the electrically conducting member 58. The electrode assembly 100 comprises a plasma-ignition, glow-discharge electrode 102, which is in the form of an elongate, high voltage electrode located concentrically within, but spaced from, the tube 62 of the electrically conducting member 58. A connector 104 connects the electrode 102 with a power supply. The electrode 102 may be threaded into a conformingly-threaded aperture located concentrically with the lock nut 90. A gas inlet 106 is formed within the tube 62 for receiving a flow of a glow-discharge gas, such as nitrogen, a noble gas, or any other substantially inert and ionisable gas, from a gas inlet port 108 extending radially through the first body portion 66 of the holder 60. The gas inlet port 108 receives the glow-discharge gas from a connector 110 attached to the holder for connecting the gas inlet port 108 to a source of the glow-discharge gas. The gas inlet 106 is preferably arranged tangentially with respect to the bore of the tube 62 of the electrically conducting member 58 to promote formation of a helical flow path around electrode 102 generally downwardly towards the tip 64 of the electrically conducting member 58.

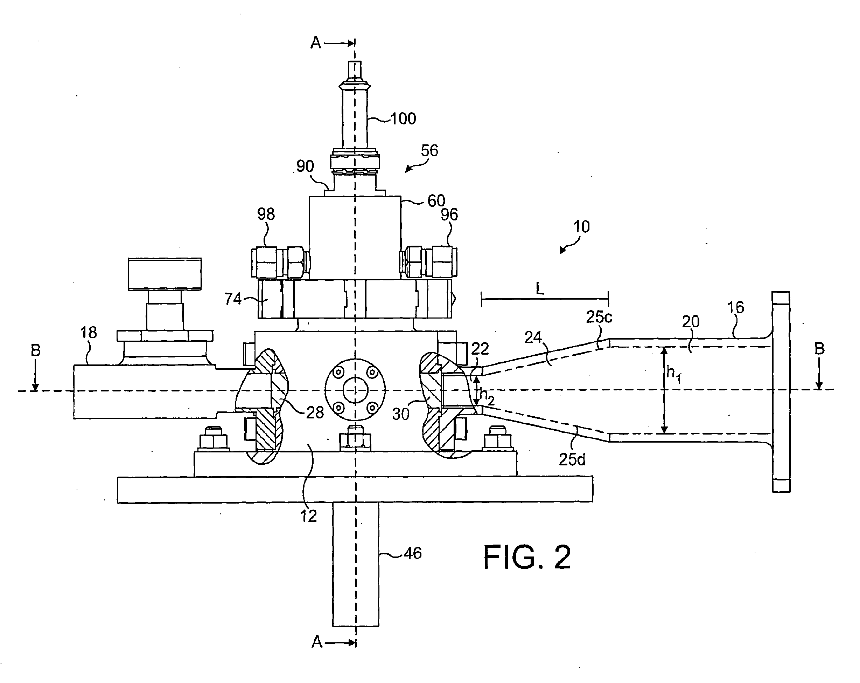

As illustrated in Figure 2, when the holder 60 is mounted on the housing 12, the electrically conducting member 58 extends into the bore 54 substantially perpendicular to the direction of propagation of the microwaves through the gas chamber 36, and is substantially co-axial with both the gas chamber 36 and the gas outlet port 44. The tip 64 of the electrically conducting member 58 is preferably located at a maximum intensity of the electromagnetic field formed within the resonant cavity 14 during use of the abatement device 10.

During normal use of the abatement device 10, a flow of cooling water is supplied to the annular channel 94. A gas is pumped into gas chamber 36 through the gas inlet port 40, flows spirally within the gas chamber 36 and passes beneath the tip 64 of the electrically conducting member 58 before leaving the gas chamber 36 through the gas outlet port 44 and entering the second gas conduit 46.

Microwave radiation is fed into the resonant cavity 14, and thus into the gas chamber 36, for a magnetron by the waveguide 16. The end plate 26 of the short circuit 18 reflects the microwaves to form a standing wave within the resonant cavity 14, with the tip 64 of the electrically conducting member 58 intensifying the electric field within the gas chamber 36. The tapered portion 24 of the waveguide 16 serves to inhibit the transmission and reflection of microwave radiation from the interface between the first and second body portions 20, 22 of the waveguide 16 whilst maximising the energy absorption of the plasma. The geometry and position of the lower surface 112 of the skirt 68 of the holder 60 relative to the tip 64 of the electrically conducting member 58 is chosen so that the lower surface 112 of the skirt 68 provides, with the inner surface of the bore 54 of the housing 12 and the outer surface of the second body portion of the holder 60, a co-axial tuner for matching the impedance in the plane of the electrically conducting member 58 to the impedance of the waveguide 16 at the frequency of the microwave radiation.

When a glows-discharge electrode assembly 100 is used to ignite a plasma within the gas chamber 36, the glow-discharge gas is caused to flow through the gas inlet port 106 of the tube 62 and into the bore of the tube 62. A low-voltage, high-current source is connected to the electrode 102, and a high voltage is applied temporarily to the electrode 102. The high voltage results in a corona discharge through the glow-discharge gas from the tip of the electrode 102 towards a proximal portion of the tube 62. That corona discharge provides a path through which a large current from the low voltage source can flow to ground. Flow of the large current causes formation of a glow discharge in the glow-discharge gas. The glow discharge thus formed is caused by the flow of the glow-discharge gas within the tube 62 to move from the tip 64 of the electrically conducting member 58 into the gas chamber 36. Microwave radiation within the gas chamber 36 is able to couple efficiently to the glow discharge and, in typically less than one second, the plasma ignites, leading to a stable microwave plasma which can be maintained by means of the microwave radiation supplied to the gas chamber 36 alone after the power supply to the electrode 102 is switched off (typically within two or three seconds).

The plasma initiated within the gas chamber 36 is carried out from the gas chamber 36 through the gas outlet port 44 with the gas flowing through the gas chamber 36, and is contained within the second gas conduit 46. The plasma thus resembles a flame generated beneath the tip 64 and extending out through the gas outlet port 44 into the second gas conduit 46. Due to the high temperature created within the second gas conduit 46 during use of the abatement device 10, a coolant such as water may be sprayed over the outer surface of the second gas conduit 46 to cool the second gas conduit 46.

The microwave plasma generated within the gas chamber 36 may be used for a number of purposes. One such purpose is for the treatment of a gas exhaust from a semiconductor process chamber. Depending on the nature of the processes taking place in the process chamber, varying amounts of harmful perfluorocompound gases such as CF₄, C₂F₆, CHF₃, NF₃ or SF₆, silane and ammonia may be present within the exhaust gas. These gases can be removed from the gas with high efficiency using the abatement device 10. Water vapour for reacting with these gases can be added to the exhaust gas upstream from the abatement device 10, for example by passing the exhaust gas through a wet pre-scrubber or by adding a stream of water vapour to the exhaust gas. Within the gas chamber 36, these gases react with the water vapour to form gases such as CO₂ and HF, which can be subsequently removed from the exhaust gas by a wet scrubber located downstream from the abatement device 10.

Problems can arise when the exhaust gas contains gases such as HBr, HCl, Br₂ and Cl₂. HBr and HCl present in the chamber 36, together with HF generated as a by-product of a reaction occurring within the gas chamber 36, can strip the passive surface oxide layers from the stainless steel surfaces of the housing 12 and nozzle holder 60, exposing the stainless steel. Water vapour present within the exhaust gas entering the gas chamber 36 can adsorb on to the exposed stainless steel surfaces, and promote corrosion of these surfaces by the reaction of HBr, HCl, Br₂ or Cl₂ with metallic constituents of the stainless steel. As well as degrading the surfaces of these stainless steel components, the by-products from the corrosion can interfere with the microwaves entering the resonant cavity 14, and this can lead to a reduction in the destruction and removal efficiency of the gas treatment taking place within the gas chamber 36.

In view of this, when the gas entering the gas chamber 36 is likely to contain a halocompound such as HBr, HCl, Br₂ or Cl₂, either simultaneously with water vapour or separately therefrom, prior to pumping the gas into gas chamber 36 through the gas inlet port 40, the gas chamber 36 is heated to a temperature that inhibits adsorption of water on the stainless steel surfaces within the gas chamber 36. This temperature is preferably in excess of 100°C, in this example around 120°C, to minimise the risk of any water adsorption on the stainless steel surfaces within the gas chamber 36.

The gas chamber 36 may be heated by igniting a plasma within the gas chamber 36 from the glow-discharge gas, and maintaining that plasma with the supply of microwave radiation for a period of time sufficient to raise the temperature of the gas chamber to around 120°C before the gas enters the gas chamber 36 through the gas inlet 40. Alternatively, the housing 12 may be externally heated to raise the temperature of the gas chamber 36 above 120°C.

During use of the abatement device 10 to treat the gas entering the gas chamber 36 through gas inlet 40, it is then necessary to maintain the temperature of the gas chamber 36 at or above a temperature that inhibits the water adsorption. In view of this, in the preferred embodiment the abatement device 10 includes a chamber temperature control circuit for controlling the temperature of the gas chamber 36.

With reference to Figures 3 and 5, the housing 12 includes a fluid cavity 120 located adjacent the gas chamber 36. In this embodiment, the fluid cavity 120 extends about the gas outlet 44 from the gas chamber 36. A thermal fluid, such as pressurised steam, hot silicone oil or other diathermic fluid is being supplied to the fluid cavity 120 through a fluid inlet port 122 passing the housing 12 and which receives thermal fluid from a first external connector 124. The thermal fluid is exhausted from the fluid cavity 120 through fluid outlet port (not shown) also passing through the housing 12 and located adjacent the fluid inlet port 122. A second external connector 126 located adjacent the first external connector 124 receives the thermal fluid from the fluid outlet port.

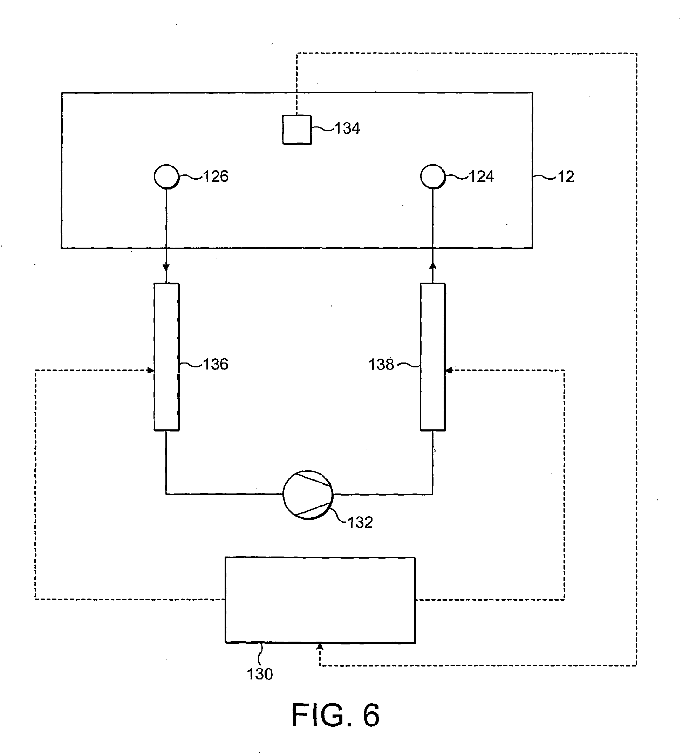

With reference to Figure 6, the fluid cavity 120 forms part of the chamber temperature control circuit 130 for controlling the temperature of the gas chamber 36. A flow of thermal fluid is circulated within the circuit 130 by a pump 132. The flow of fluid enters the fluid cavity from connector 124, circulates about the cavity 120 before being exhaust from the cavity 120 through connector 126, thereby controlling the temperature of the adjacent gas chamber 36.

The temperature of the thermal fluid is controlled by a controller 130 which receives signals indicative of the temperature of the gas chamber 36 from a sensor 134 which, as illustrated in Figure 6, may be mounted on the external surface of the housing 12 proximate the gas chamber 36 or at any other location suitable for detecting the temperature of the gas chamber 36. In response to those signals, the controller 130 controls one or more heat exchangers 136, 138 for controlling the temperature of the thermal fluid.

To avoid overheating, the gas chamber 36 is operated within the temperature range from 120 to 180°C.

When the signals output from the sensor 134 indicate that the temperature of the gas chamber 36 is towards the top end of this temperature range, due to the heat generated by the plasma within the gas chamber 36, the controller 130 operates a first heat exchanger 136 to cool the thermal fluid to a first temperature below this temperature range, for example around or less than 100°C, so that the thermal fluid serves to reduce the temperature of the gas chamber 136 as it passes through the fluid cavity 120. When the signals output from the sensor 134 indicate that the temperature of the chamber 36 is towards the bottom end of this temperature range, for example after a period of cooling by the relatively cold thermal fluid, the controller 130 operates a second heat exchanger 138 to heat the thermal fluid to a second temperature within or above this temperature range, for example around or above 120°C, so that the thermal fluid serves to raise the temperature of the gas chamber 36 as it passes through the fluid cavity 120. Optionally, the first heat exchanger 136 need not be operated during operation of the second heat exchanger, and vice versa, and so the circuit 120 may be configured to enable one, or both, of the heat exchangers to be selectively by-passed depending on the temperature of the gas chamber 36.

In this example, a direct, active method is used to control the temperature of the gas chamber. However an indirect method may be employed, as outlined below.

First, the nominal and maximum continuous operating temperatures for the gas chamber 36 may be decided, for example 120 to 130°C. Next, the maximum heat dissipation from the microwave power source (power losses and plasma losses) may be determined, by calculation, estimation or measurement. Knowing the specific heat capacity of the thermal fluid, the flow rate to limit the maximum temperature as previously determined may be derived. The first heat exchanger 136 may then be designed to dissipate a little more energy than that absorbed in the gas chamber 36 and the second heat exchanger 138 may then be employed to control the temperature of the circulating thermal fluid to the required temperature (120°C in this example) so that the temperature control of the gas chamber 36 is indirect, that is, through temperature control of the circulating thermal fluid on the fluid inlet to the gas chamber 36.

In addition to being used to maintain the temperature of the gas chamber 36 within the selected temperature range, the circuit 120 may also be used to initially heat the gas chamber 36 before the gas to be treated enters the gas chamber 36.

## Claims

1. A method of treating a gas containing varying amounts of a halocompound and water vapour, the method comprising the steps of providing a plasma abatement device (10) comprising a gas chamber (36) having a gas inlet (40) for receiving the gas and a gas outlet (44), heating the chamber to a temperature that inhibits adsorption of water on a stainless steel surface within the chamber (36), conveying the gas to the gas chamber for treatment thereof within the chamber, **characterised in that** the chamber is maintained within the range from 120°C to 180°C during treatment of the gas.

2. A method according to Claim 1, wherein the chamber (36) is heated to at least 120°C before the gas is conveyed to the chamber.

3. A method according to any preceding claim, wherein the chamber is maintained above said temperature by flowing a heat transfer fluid through a chamber temperature control circuit (130) for controlling the temperature of the chamber, and controlling the temperature of the fluid.

4. A method according to Claim 3, wherein the chamber temperature control circuit is located in part within a wall of the chamber.

5. A method according to Claim 3 or Claim 4, wherein the chamber temperature control circuit extends about the gas outlet.

6. A method according to any of Claims 4 to 5, wherein the temperature of the fluid is controlled by flowing the fluid through heat exchange means, and controlling the heat exchange means to control the temperature of the fluid.

7. A method according to Claim 6, wherein the heat transfer fluid is conveyed through at least one of a first heat exchanger to selectively cool the fluid to a first fluid temperature, and a second heat exchanger to selectively heat the fluid to a second fluid temperature greater than the first fluid temperature.

8. A method according to Claim 7, wherein the first fluid temperature is lower than 120°C, and the second temperature is at least 120°C.

9. A method according to any of Claims 3 to 8, wherein the heat transfer fluid comprises a diathermic fluid.

10. A method according to any of Claims 3 to 9, wherein the chamber is heated to said temperature by the heat transfer fluid prior to supply of the gas to the chamber.

11. A method according to any preceding claim, wherein the plasma abatement device comprises a microwave plasma abatement device.

12. A method according to any preceding claim, wherein the gas is treated at or around atmospheric pressure.

13. A method according to any preceding claim, wherein the halocompound comprises one of a hydrogen halide, such as hydrogen bromide or hydrogen chloride, Br₂ and Cl₂.

14. A plasma abatement device (10) comprising a gas chamber (36) having a gas inlet (40) for receiving a gas to be treated by the device and a gas outlet (44), and thermal control means for maintaining the chamber at a temperature that inhibits adsorption of water on a stainless steel surface within the chamber during treatment of a gas containing a halocompound and water vapour,
**characterised** the thermal control means is configured to maintain the chamber within a temperature range from 120°C to 180°C during treatment of the gas

15. A device according to Claim 14 wherein the thermal control means comprises a chamber temperature control circuit (130) for controlling the temperature of the chamber, means for flowing a heat transfer fluid through the temperature control circuit, and control means for controlling the temperature of the fluid.

16. A device according to Claim 15, wherein the chamber temperature control circuit is located in part within a wall of the chamber.

17. A device according to Claim 15 or Claim 16, wherein the chamber temperature control circuit extends about the gas outlet.

18. A device according to any of Claims 15 to 17, wherein the thermal control means comprises heat exchange means through which the fluid is caused to flow, the control means being configured to control the heat exchange means to control the temperature of the fluid.

19. A device according to Claim 18, wherein the heat exchange means comprises a first heat exchanger to selectively cool the fluid to a first temperature, and a second heat exchanger to selectively heat the fluid to a second temperature greater than the first temperature.

20. A device according to Claim 19, wherein the first temperature is lower than the temperature range, and the second temperature is at least within the temperature range.

21. A device according to any of Claims 15 to 20, wherein the heat transfer fluid comprises a diathermic fluid.

22. A device according to any of Claims 14 to 21, wherein the gas chamber is formed from stainless steel.

23. A device according to any of Claims 14 to 22, in the form of a microwave plasma abatement device.

24. A device according to Claim 23, comprising an electrically conducting member protruding into the gas chamber, the electrically conducting member being formed from stainless steel.

## Patentansprüche

1. Verfahren zum Behandeln eines Gases, das variierende Mengen einer Halogenverbindung und Wasserdampf enthält, wobei das Verfahren die Schritte des Bereitstellens einer Plasmavernichtungseinrichtung (10) mit einer Gaskammer (36) mit einem Einlass (40) zur Aufnahme des Gases und einem Gasauslass (44), des Erwärmens der Kammer auf eine Temperatur, welche die Adsorption von Wasser auf einer rostfreien Stahloberfläche innerhalb der Kammer (36) hemmt, und des Beförderns des Gases in die Gaskammer zur Behandlung desselben in der Kammer umfasst, **dadurch gekennzeichnet, dass** die Kammer während der Behandlung des Gases im Bereich von 120 °C bis 180 °C gehalten wird.

2. Verfahren nach Anspruch 1, wobei die Kammer (36) auf mindestens 120 °C erwärmt wird, bevor das Gas in die Kammer befördert wird.

3. Verfahren nach irgendeinem vorhergehenden Anspruch, wobei die Kammer oberhalb der genannten Temperatur gehalten wird, indem ein Wärmeübertragungsmedium durch einen Kammertemperatur-Steuerkreislauf (130) geleitet wird, um die Temperatur der Kammer zu steuern, und durch Steuerung der Temperatur des Mediums.

4. Verfahren nach Anspruch 3, wobei der Kammertemperatur-Steuerkreislauf teilweise innerhalb einer Wand der Kammer angeordnet ist.

5. Verfahren nach Anspruch 3 oder Anspruch 4, wobei der Kammertemperatur-Steuerkreislauf sich um den Gasauslass erstreckt.

6. Verfahren nach einem der Ansprüche 4 bis 5, wobei die Temperatur des Mediums gesteuert wird, indem das Medium durch Wärmeaustauschmittel geleitet wird, und das Wärmeaustauschmittel zur Steuerung der Temperatur des Mediums gesteuert wird.

7. Verfahren nach Anspruch 6, wobei das Wärmeaustauschmedium durch mindestens einen von einem ersten Wärmetauscher zum wahlweisen Kühlen des Mediums auf eine erste Mediumstemperatur und einen zweiten Wärmetauscher zum wahlweisen Erwärmen des Mediums auf eine zweite Mediumstemperatur befördert wird, die größer als die erste Mediumstemperatur ist.

8. Verfahren nach Anspruch 7, wobei die erste Mediumstemperatur niedriger als 120 °C ist, und die zweite Temperatur mindestens 120 °C beträgt.

9. Verfahren nach einem der Ansprüche 3 bis 8, wobei das Wärmeübertragungsmedium ein diathermisches Medium ist.

10. Verfahren nach einem der Ansprüche 3 bis 9, wobei die Kammer auf die genannte Temperatur durch das Wärmeübertragungsmedium vor der Zufuhr des Gases in die Kammer erwärmt wird.

11. Verfahren nach irgendeinem vorhergehenden Anspruch, wobei die Plasmavernichtungseinrichtung eine Mikrowellen-Plasmavernichtungseinrichtung ist.

12. Verfahren nach irgendeinem vorhergehenden Anspruch, wobei das Gas auf oder um Atmosphärendruck behandelt wird.

13. Verfahren nach irgendeinem vorhergehenden Anspruch, wobei die Halogenverbindung eine aus einem Wasserstofflialid, wie beispielsweise Wasserstoffbromid oder Wasserstoffchlorid, Br₂ und Cl₂ , umfasst.

14. Plasmavernichtungseinrichtung (10) mit einer Gaskammer (36) mit einem Gaseinlass (40) zur Aufnahme von durch die Einrichtung zu behandelndem Gas und einem Gasauslass (44), und mit Wärmesteuermitteln zum Halten der Kammer auf einer Temperatur, die Adsorption vom Wasser auf einer rostfreien Stahloberfläche innerhalb der Kammer während der Behandlung eines Gases, das eine Halogenverbindung und Wasserdampf enthält, hemmt,
**dadurch gekennzeichnet, dass** die Wärmesteuermittel so konfiguriert sind, dass sie die Kammer innerhalb eines Temperaturbereichs von 120 °C bis 180 °C während der Behandlung des Gases halten.

15. Einrichtung nach Anspruch 14, wobei die Wärmesteuermittel einen Kammertemperatur-Steuerkreislauf (130) zur Steuerung der Temperatur der Kammer, Mittel zum Leiten eines Wärmeübertragungsmediums durch den Temperatur-Steuerkreislauf, und Steuermittel zum Steuern der Temperatur des Mediums umfassen.

16. Einrichtung nach Anspruch 15, wobei der Kammertemperatur-Steuerkreislaufteilweise innerhalb einer Wand der Kammer angeordnet ist.

17. Einrichtung nach Anspruch 15 oder Anspruch 16, wobei der Kammertemperatur-Steuerkreislauf sich um den Gasauslass herum erstreckt.

18. Einrichtung nach einem der Ansprüche 15 bis 17, wobei die Wärmesteuermittel Wärmeaustauschmittel umfassen, durch welche das Medium geleitet wird, wobei die Steuermittel so konfiguriert sind, dass sie die Wärmeaustauschmittel zur Steuerung der Temperatur des Mediums steuern.

19. Einrichtung nach Anspruch 18, wobei die Wärmeaustauschmittel einen ersten Wärmetauscher zum wahlweisen Kühlen des Mediums auf eine erste Temperatur und einen zweiten Wärmetauscher zum wahlweisen Erwärmen des Mediums auf eine zweite Temperatur aufweisen, die größer als die erste Temperatur ist.

20. Einrichtung nach Anspruch 19, wobei die erste Temperatur niedriger als der Temperaturbereich ist, und die zweite Temperatur mindestens innerhalb des Temperaturbereichs liegt.

21. Einrichtung nach einem der Ansprüche 15 bis 20, wobei das Wärmeübertragungsmedium ein diathermisches Medium ist.

22. Einrichtung nach einem der Ansprüche 14 bis 21, wobei die Gaskammer aus rostfreiem Stahl gebildet ist.

23. Einrichtung nach einem der Ansprüche 14 bis 22 in Form einer Mikrowellen-Plasmavernichtungseinrichtung.

24. Einrichtung nach Anspruch 23 mit einem elektrisch leitenden Bauteil, das in die Gaskammer hinein vorspringt, wobei das elektrisch leitende Bauteil aus rostfreiem Stahl gebildet ist.

## Revendications

1. Procédé de traitement d'un gaz contenant des quantités variées d'un composé halogéné et de vapeur d'eau, le procédé comprenant les étapes de fourniture d'un dispositif (10) d'abattement par plasma comprenant une chambre (36) pour le gaz ayant une entrée (40) de gaz pour recevoir le gaz et une sortie (44) de gaz, de chauffage de la chambre à une température qui empêche l'adsorption d'eau sur une surface en acier inoxydable à l'intérieur de la chambre (36), d'acheminement du gaz jusqu'à la chambre pour le gaz pour le traitement de celui-ci à l'intérieur de la chambre, ***caractérisé en ce que*** la chambre est maintenue dans une plage de températures de 120°C à 180°C pendant le traitement du gaz.

2. Procédé selon la revendication 1, dans lequel la chambre (36) est chauffée jusqu'à au moins 120°C avant que le gaz ne soit acheminé jusqu'à la chambre.

3. Procédé selon l'une quelconque des revendications précédentes, dans lequel la chambre est maintenue au-dessus de ladite température par la circulation d'un fluide caloporteur dans un circuit (130) de régulation de la température de la chambre destiné à réguler la température de la chambre, et par la régulation de la température du fluide.

4. Procédé selon la revendication 3, dans lequel le circuit de régulation de la température de la chambre est situé en partie dans une paroi de la chambre.

5. Procédé selon la revendication 3 ou la revendication 4, dans lequel le circuit de régulation de la température de la chambre s'étend autour de la sortie de gaz.

6. Procédé selon l'une quelconque des revendications 4 à 5, dans lequel la température du fluide est régulée en faisant circuler le fluide dans des moyens d'échange de chaleur, et en contrôlant les moyens d'échange de chaleur pour réguler la température du fluide.

7. Procédé selon la revendication 6, dans lequel le fluide caloporteur est acheminé dans au moins l'un d'entre un premier échangeur de chaleur destiné à refroidir sélectivement le fluide à une première température de fluide, et un deuxième échangeur de chaleur destiné à réchauffer sélectivement le fluide à une deuxième température de fluide supérieure à la première température de fluide.

8. Procédé selon la revendication 7, dans lequel la première température de fluide est inférieure à 120°C, et la deuxième température est d'au moins 120°C.

9. Procédé selon l'une quelconque des revendications 3 à 8, dans lequel le fluide caloporteur comprend un fluide diathermique.

10. Procédé selon l'une quelconque des revendications 3 à 9, dans lequel la chambre est chauffée à ladite température par le fluide caloporteur avant la fourniture du gaz à la chambre.

11. Procédé selon l'une quelconque des revendications précédentes, dans lequel le dispositif d'abattement par plasma comprend un dispositif d'abattement par plasma micro-onde.

12. Procédé selon l'une quelconque des revendications précédentes, dans lequel le gaz est traité à la pression atmosphérique ou à une pression proche de celle-ci.

13. Procédé selon l'une quelconque des revendications précédentes, dans lequel le composé halogéné comprend l'un parmi un halogénure d'hydrogène, tel le bromure d'hydrogène ou le chlorure d'hydrogène, Br₂ et Cl₂.

14. Dispositif (10) d'abattement par plasma comprenant une chambre (36) pour un gaz ayant une entrée (40) de gaz pour recevoir le gaz devant être traité par le dispositif, et une sortie (44) de gaz, et des moyens de régulation thermique pour maintenir la chambre à une température empêchant l'adsorption d'eau sur une surface en acier inoxydable située à l'intérieur de la chambre lors du traitement d'un gaz contenant un composé halogéné et de la vapeur d'eau,
***caractérisé en ce que*** les moyens de régulation thermique sont configurés pour maintenir la chambre dans une plage de températures de 120°C à 180°C pendant le traitement du gaz.

15. Dispositif selon la revendication 14, dans lequel les moyens de régulation thermique comprennent un circuit (130) de régulation de la température de la chambre destiné à réguler la température de la chambre, des moyens pour faire circuler un fluide caloporteur dans le circuit de régulation de la température, et des moyens de régulation pour réguler la température du fluide.

16. Dispositif selon la revendication 15, dans lequel le circuit de régulation de la température de la chambre est situé en partie dans une paroi de la chambre.

17. Dispositif selon la revendication 15 ou la revendication 16, dans lequel le circuit de régulation de la température de la chambre s'étend autour de la sortie pour le gaz.

18. Dispositif selon l'une quelconque des revendications 15 à 17, dans lequel les moyens de régulation thermique comprennent des moyens d'échange de chaleur à travers lesquels circule le fluide, les moyens de régulation étant configurés pour réguler les moyens d'échange de chaleur afin de réguler la température du fluide.

19. Dispositif selon la revendication 18, dans lequel les moyens d'échange de chaleur comprennent un premier échangeur de chaleur pour refroidir de manière sélective le fluide à une première température, et un deuxième échangeur de chaleur pour réchauffer de manière sélective le fluide à une deuxième température supérieure à la première température.

20. Dispositif selon la revendication 19, dans lequel la première température est inférieure à la plage de températures, et la deuxième température est au moins dans la plage de températures.

21. Dispositif selon l'une quelconque des revendications 15 à 20, dans lequel le fluide caloporteur comprend un fluide diathermique.

22. Dispositif selon l'une quelconque des revendications 14 à 21, dans lequel la chambre pour le gaz est faite d'acier inoxydable.

23. Dispositif selon l'une quelconque des revendications 14 à 22, prenant la forme d'un dispositif d'abattement par plasma micro-onde.

24. Dispositif selon la revendication 23, comprenant un élément électro-conducteur faisant saillie dans la chambre pour le gaz, l'élément électro-conducteur étant fait d'acier inoxydable.
